# EUROPEAN PATENT SPECIFICATION

(11) **EP 2 006 161 B1**
(45) Date of publication and mention of the grant of the patent: **14.07.2010**
(21) Application number: 07425298.2
(22) Date of filing: 21.05.2007
(51) Int. Cl.: B60R 16/023, H05K 5/00, H05K 7/20

(54) **An electronic control unit with a central elastic element**
Elektronische Steuereinheit mit einem zentralen elastischen Element
Unité de contrôle électronique avec un élément central élastique

(43) Date of publication of application: 24.12.2008
(73) Proprietor: Magneti Marelli S.p.A., Corbetta (MI) (IT)
(72) Inventor: Fino, Endrio, 10090 Romano Canavese (IT); Cicognati, Fulvio, 10023 Chieri (IT)
(74) Representative: Jorio, Paolo

(56) References cited:
- EP-A- 1 289 011
- GB-A- 2 366 668
- US-A1- 2003 143 871
- US-A1- 2003 161 110
- US-A1- 2004 095 732

## Description

The present invention relates to an electronic control unit.

The present invention finds advantageous application in an electronic control unit of an internal combustion engine, to which explicit reference will be made in the following description without because of this loosing in generality.

An electronic control unit for an internal combustion engine comprises a PCB (Printed Circuit Board), which supports an electronic circuit, a plurality of electric/electronic components electrically connected to the electric circuit, and at least one connector electrically connected to the electric circuit for connecting the electronic control unit to the internal combustion engine wiring. The printed circuit board is accommodated in a housing, which comprises a base which inferiorly supports the printed circuit board and a lid which superiorly closes the base.

Generally, in addition to its natural containing and mechanical protection function, base of housing performs the function of heat sink for dissipating the heat which is produced by electric/electronic components. For this reason, some constructive solutions contemplate that the printed circuit board is maintained pressed against the base of the housing by means of at least one central fastening screw which is arranged through a through hole obtained through the printed circuit board and is screwed into a blank threaded hole obtained through the base of the housing.

However, the presence of the fastening screw increases the assembly costs due to the need to manage the additional component constituted by fastening screw, perforating the printed circuit board, perforating and threading the housing base and screwing the fastening screw. Furthermore, the need to make a blank threaded hole for the fastening screw in the base of the housing obliges to make the base of the housing with an at least locally high thickness.

US2003143871A1 discloses an electronic device including a circuit board supporting an electronic circuit, a flexible printed wiring board, and an electric connector.

It is the object of the present invention to make an electronic control unit which is free from the above-described drawbacks and is specifically easy and cost-effective to manufacture.

According to the present invention, an electronic control unit is made as claimed in the accompanying claims.

The present invention will now be described with reference to the accompanying drawings which illustrate a non-limitative example of embodiment thereof, in which:
- figure 1 is a perspective, exploded, diagrammatic view with parts removed for clarity of an electronic control unit for an internal combustion engine made according to the present invention;
- figure 2 is a further perspective, exploded, diagrammatic view with parts removed for clarity of the electronic control unit in figure 1;
- figure 3 is a side section view of the electronic control unit in figure 1;
- figure 4 is a bottom view of the electronic control unit in figure 1; and
- figures 5 and 6 are two side section views of a fastening fin of the electronic control unit in figure 1 in an assembly configuration and in a fastening configuration, respectively.

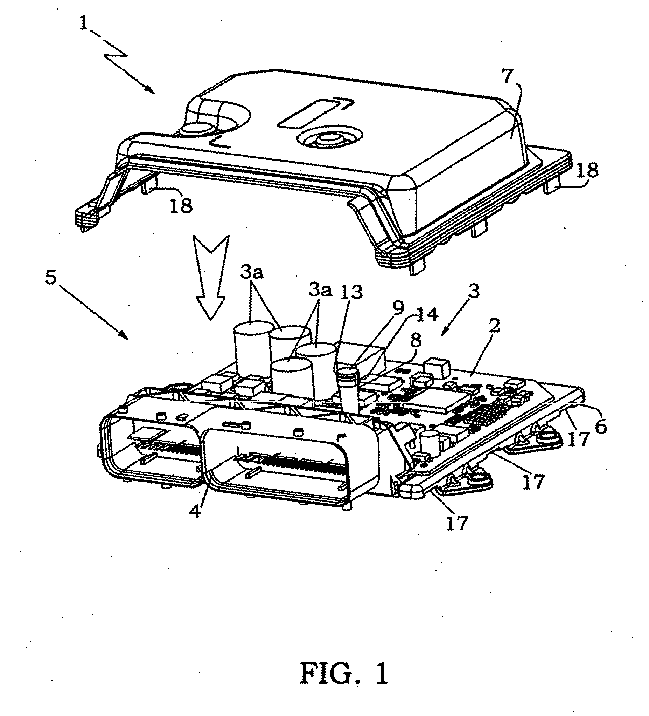

In figure 1, numeral 1 indicates as a whole an electronic control unit for an internal combustion engine.

Electronic control unit 1 comprises a printed circuit board 2, which supports an electric circuit, a plurality of electric/electronic components 3 electrically connected to the electric circuit, and a connector 4 electrically connected to the electric circuit to connect electronic control unit 1 to the internal combustion engine wiring. Specifically, printed circuit board 2 supports four electrolytic capacitors 3a, which have a cylindrical shape and present large dimensions and a heavy mass.

Furthermore, electronic control unit 1 comprises a housing 5, which presents a rectangular shape in plan, accommodates therein printed circuit board 2 and comprises a base 6 which inferiorly supports printed circuit board 2 and a lid 7 which superiorly closes base 6. In addition to its natural containing and mechanical protection function, base 6 of housing 5 performs the function of heat sink for dissipating the heat which is produced by electric/electronic components 3. Consequently, printed circuit board 2 is arranged in contact with base 6 of housing 5 and a paste which is thermally conducting and electrically insulating may be interposed between the lower surface of printed circuit board 2 and the upper surface of base 6 of housing 5 in order to increase the heat exchange.

According to a preferred embodiment, base 6 and lid 7 of housing 5 are formed by aluminium sheet using pressing technology by cold rolling of aluminium castings; in the embodiment shown in the accompanying figures, base 6 has a thickness of 2.5 mm and lid 7 has a thickness of 1.5 mm.

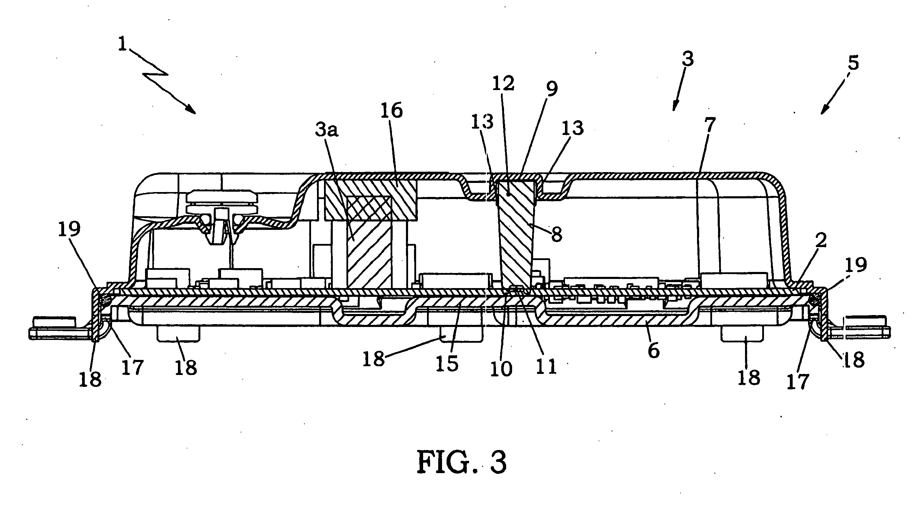

As shown in figure 3, in order to increase the heat exchange between printed board circuit 2 and base 6 of housing 5, it is necessary to keep printed circuit board 2 pressed against base 6 of housing 5 with a certain force. For this purpose, electronic control unit 1 comprises at least one pressing element 8, which is formed by elastically deformable material, is arranged in central position and is compressed between lid 7 and printed circuit board 2 for pressing with interference against printed circuit board 2.

Pressing element 8 presents a frustum-shape having a larger base 9 resting on lid 7 and a smaller base 10 resting on printed circuit board 2. According to a possible embodiment shown in the accompanying figures, smaller base 10 of pressing element 8 rests against printed circuit board 2 is rounded and presents a central blank hole 11. The function of central blank hole 11 is to confer a "suction cap" effect to smaller base 10 resting on printed circuit board 2 for increasing the transversal withholding force.

According to a preferred embodiment shown in the accompanying figures, lid 7 comprises an annular seat 12 which is cup-shaped and accommodates larger base 9 of pressing element 8 resting on lid 7. In order to increase the withholding force of pressing element 8 within seat 12, pressing element 8 presents two annular bulges 13 which are dimensioned by interference within seat 12. Moreover, in order to further increase the withholding force of pressing element 8 within seat 12, larger base 9 of pressing element 8 is fixed to lid 7 by gluing; i.e. a drop of glue (resin) is inserted inside seat 12 before driving larger base 9 of pressing element 8 inside seat 12. Preferably, pressing element 8 presents two axial side channels 14 to relieve the glue in excess at base 9; i.e. the glue in excess present inside seat 12 may leak from seat 12 during the driving of larger base 9 of pressing element 8 through two side channels 14.

According to a preferred embodiment, pressing element 8 is formed by silicone having for example a hardness of 80 ± 5 shoreA. In the embodiment shown in the accompanying figures, pressing element 8 has a total height of 27 mm, larger base 9 has a diameter of 10 mm, smaller base 10 has a diameter of 7 mm and central blank hole 11 of smaller base 10 has a diameter of 4 mm. Furthermore, in the embodiment shown in the accompanying figures, pressing element 8 is compressed between lid 7 and printed circuit board 2 with a theoretical interference equal to 1.2 mm (more generally comprised between 1 mm and 1.5 mm).

According to a preferred embodiment, base 6 of housing 5 presents a contrast plane 15, which is arranged at pressing element 8 and constitutes a resting surface for printed circuit board 2 so as to act as a mechanical contrast for pressing element 8. In other words, without contrasting plane 15, printed circuit board 2 would centrally bend in undesired manner under the bias of pressing element 8.

According to a preferred embodiment, printed circuit board 2 is free from electric/electronic components 3 and weldings in the resting zone of pressing element 8 in order to prevent possible electric/electronic components 3 from being damaged in time by the pressure exerted by pressing element 8.

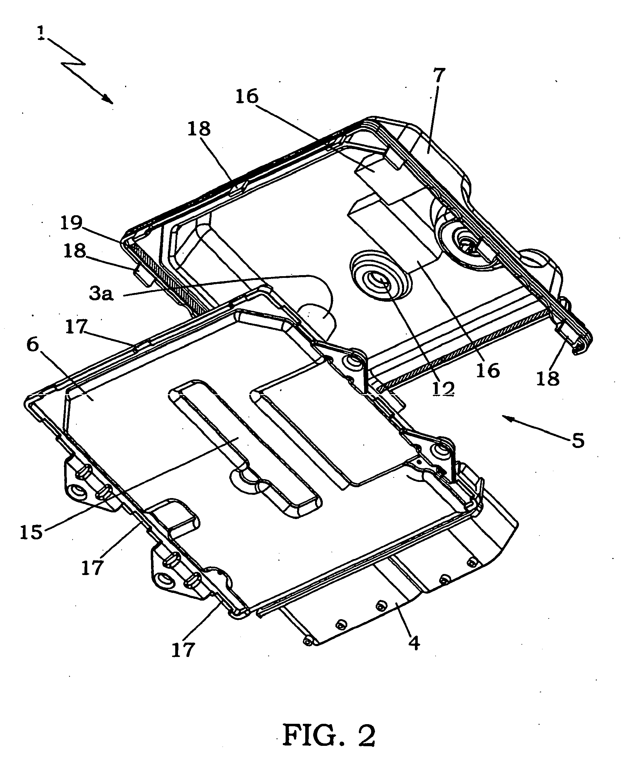

As shown in figures 2 and 3, electronic control unit 1 comprises two blocking blocks 16 formed by deformable, expanded, elastic material, each of which is fixed (preferably glued) to an internal surface of lid 7 at two corresponding electrolytic capacitors 3a, presents a sufficient thickness so as to determine a vertical interference with the corresponding two electrolytic capacitors 3a to be compressed between lid 7 and electrolytic capacitors 3a, and presents a larger area with respect to electrolytic capacitors 3a to laterally encompass electrolytic capacitors 3a themselves.

In order words, each blocking block 16 by deforming superiorly and laterally encompasses corresponding electrolytic capacitors 3a contributing both to the axial withholding and to the lateral withholding of electronic capacitors 3a themselves. In virtue of the slight axial compression exerted by blocking blocks 16 on electrolytic capacitors 3a, electrolytic capacitors 3a themselves are essentially free from significant vibrations.

In the embodiment shown in the accompanying figures, each undeformed blocking block 16 presents a thickness of 10 mm and presents an interference of approximately 5 mm with electrolytic capacitors 3a.

According to a preferred embodiment, blocking blocks 16 are formed by open-cell expanded material because such material presents an optimal response to vibrations. For example, blocking blocks 16 may be formed by expanded polyurethane resin presenting a PPI equal to 20 and an ISO 845 density from 26 to 32 kg/m³.

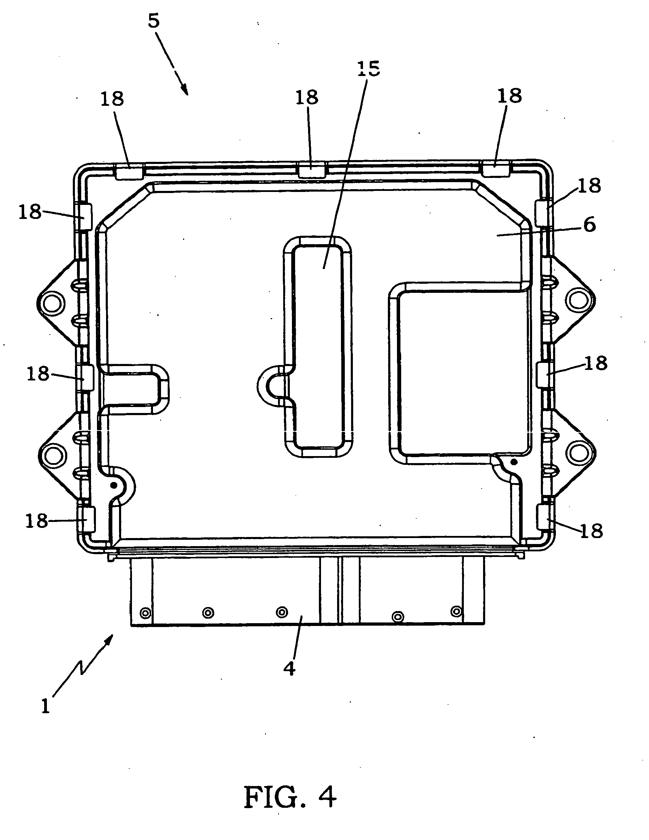

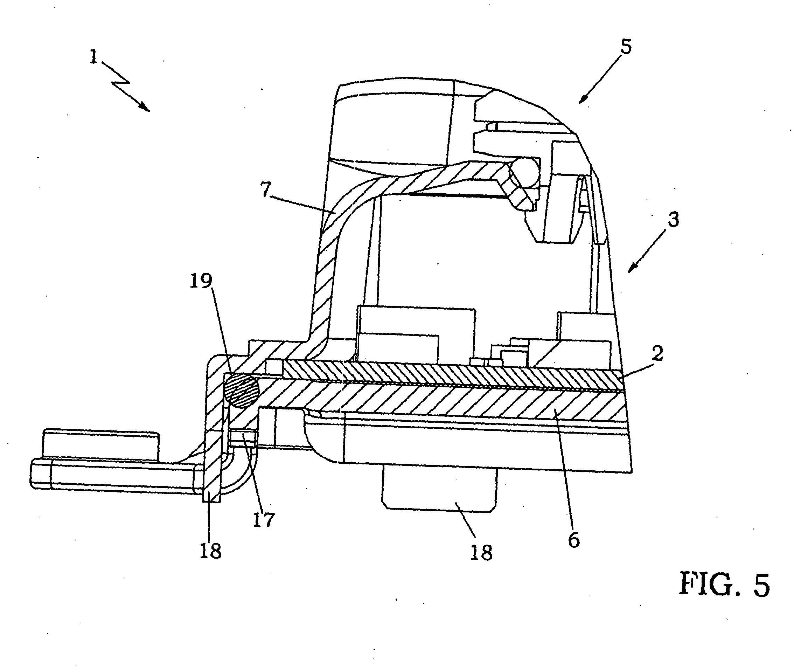

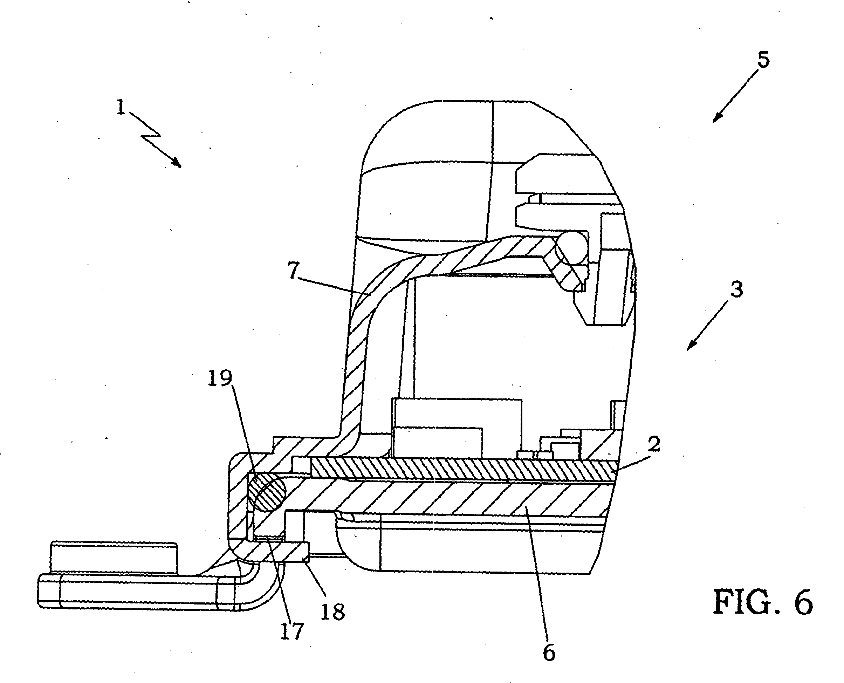

As shown in figures 2-6, base 6 comprises a plurality of fastening seats 17 and lid 7 comprises a plurality of fastening fins 18, each of which is arranged at a corresponding fastening seat 17, is initially flat (figure 5), and is adapted to be plastically folded by at least 90° inside corresponding fastening seat 17 and against base 6 for fixing lid 7 to base 6 (figure 6).

In order words, lid 7 is fixed to base 6 by means of metallic fastening fins 17, which are integrally obtained in lid 7 (i.e. are monolithic with lid 7) and are plastically deformed (i.e. without subsequent elastic return) to encompass base 6; in this manner, it is possible to avoid the use of fastening screws.

According to a preferred embodiment, fastening fins 18 present a rectangular shape. Furthermore, in the embodiment shown in the accompanying figures, nine fastening fins 18 and nine fastening seats 17 symmetrically distributed in threes are contemplated on three sides of housing 5.

As shown in figures 3, 5 and 6, a resin 19 having the function of adhesive seal, which adheres to the contact surfaces by polymerizing after housing 5 is closed, is interposed between lid 7 and base 6; resin 19 is dispensed with a circular section and then compressed by closing housing 5 and filling the empty spaces.

The above-described electronic control unit 1 presents a number of advantages, because it is simple and cost-effective to manufacture and does not require any central screw to maintain printed circuit board 2 pressed against base 6 of housing 5 because this function is performed by pressing element 8. Furthermore, by being elastic pressing element 8 also acts as a vibration damper and thus reduces the mechanical stresses induced by vibrations into printed circuit board 2.

## Claims

1. An electronic control unit (1), comprising:
a printed circuit board (2), which supports an electric circuit, a plurality of electric/electronic components (3) electrically connected to the electric circuit, and at least one connector (4) electrically connected to the electrical circuit;
a housing (5), which accommodates therein the printed circuit board (2) and comprises a base (6) which inferiorly supports the printed circuit board (2) and a lid (7) which superiorly closes the base (6); and
at least one pressing element (8), which is formed by elastically deformable material, is arranged in central position and is compressed between the lid (7) and the printed circuit board (2) for pressing with interference against the printed circuit board (2);
the electronic control unit (1) is **characterized in that** a second base (10) of the pressing element (8) resting on the printed circuit board (2) presents a central blank hole (11).

2. An electronic control unit (1) according to claim 1, wherein the pressing element (8) presents a frustum shape having a larger first base (9) resting on the lid (7) and a smaller second base (10) resting on the printed circuit board (2).

3. An electronic control unit (1) according to claim 1 or 2, wherein a second base (10) of the pressing element (8) resting on the printed circuit board (2) is rounded.

4. An electronic control unit (1) according to one of the claims from 1 to 3, wherein a first base (9) of the pressing element (8) resting on the lid (7) is fixed to the lid (7) by means of gluing.

5. An electronic control unit (1) according to one of the claims from 1 to 4, wherein the lid (7) comprises a seat (12) which accommodates a first base (9) of the pressing element (8) resting on the lid (7).

6. An electronic control unit (1) according to claim 5, wherein the first base (9) of the pressing element (8) is fixed to the lid (7) by gluing.

7. An electronic control unit (1) according to claim 6, wherein at first base (9) the pressing element (8) presents at least one axial side channel (14) for relieving the glue in excess.

8. An electronic control unit (1) according to claim 5, 6 or 7, wherein at first base (9) the pressing element (8) presents at least one annular bulge (13) dimensioned by interference within the seat (12).

9. An electronic control unit (1) according to one of the claims from 1 to 8, wherein the pressing element (8) is formed by silicone.

10. An electronic control unit (1) according to claim 9, wherein the silicone has a hardness equal to 80 ± 5 shoreA.

11. An electronic control unit (1) according to one of the claims from 1 to 10, wherein the pressing element (8) has a total height of 27 mm and presents a frustum shape having a larger first base (9) resting on the lid (7) having a diameter of 10 mm and a smaller second base (10) resting on the printed circuit board (2) having a diameter of 7 mm.

12. An electronic control unit (1) according to one of the claims from 1 to 11, wherein the pressing element (8) is compressed between the lid (7) and the printed circuit board (2) with a theoretic interference from 1 mm to 1.5 mm.

13. An electronic control unit (1) according to claim 12, wherein the pressing element (8) is compressed between the lid (7) and the printed circuit board (2) with a theoretic interference equal to 1.2 mm.

14. An electronic control unit (1) according to one of the claims from 1 to 13, wherein the base (6) of the housing (5) presents a contrast plane (15), which is arranged at the pressing element (8) and constitutes a resting surface for the printed circuit board (2) so as to act as a mechanical contrast for the pressing element (8).

15. An electronic control unit (1) according to one of the claims from 1 to 14, wherein the printed circuit board (2) is free from electric/electronic components (3) and weldings in the resting zone of the pressing element (8).

## Patentansprüche

1. Elektronische Steuereinheit (1), umfassend:
eine Leiterplatte (2), die eine elektrische Schaltung, eine Vielzahl mit der elektrischen Schaltung elektrisch verbundene elektrische/elektronische Komponenten (3) und mindestens ein mit der elektrischen Schaltung elektrisch verbundenes Verbindungsstück (4) trägt;
ein Gehäuse (5), in dem die Leiterplatte (2) aufgenommen ist und das aufweist eine Basis (6), die unten die Leiterplatte (2) trägt, und einen Deckel (7), der oben die Basis (6) verschließt; und
mindestens ein Druckelement (8), das durch elastisch deformierbares Material gebildet ist, in einer zentralen Position angeordnet ist und zwischen dem Deckel (7) und der Leiterplatte (2) zum Drücken unter Eingriff gegen die Leiterplatte (2) zusammengedrückt ist;
wobei die elektronische Steuereinheit (1) **dadurch gekennzeichnet ist, dass** eine zweite Basis (10) des Druckelements (8), die an der Leiterplatte (2) anliegt, eine zentrale Blindöffnung (11) aufweist.

2. Elektronische Steuereinheit (1) nach Anspruch 1, wobei das Druckelement (8) aufweist eine Kegelstumpfform mit einer größeren ersten Basis (9), die an dem Deckel (7) anliegt, und einer kleineren zweiten Basis (10), die an der Leiterplatte (2) anliegt.

3. Elektronische Steuereinheit (1) nach Anspruch 1 oder 2, wobei eine zweite Basis (10) des Druckelements (8), die an der Leiterplatte (2) anliegt, abgerundet ist.

4. Elektronische Steuereinheit (1) nach einem der Ansprüche 1 bis 3, wobei eine erste Basis (9) des Druckelements (8), die an dem Deckel (7) anliegt, an dem Deckel (7) durch Klebstoff befestigt ist.

5. Elektronische Steuereinheit (1) nach einem der Ansprüche 1 bis 4, wobei der Deckel (7) einen Sitz (12) aufweist, der eine erste, an dem Deckel (7) anliegende Basis (9) des Druckelements (8) aufnimmt.

6. Elektronische Steuereinheit (1) nach Anspruch 5, wobei die erste Basis (9) des Druckelements (8) an dem Deckel (7) durch Klebstoff befestigt ist.

7. Elektronische Steuereinheit (1) nach Anspruch 6, wobei die erste Basis (9) des Druckelements (8) mindestens einen axialen Seitenkanal (14) zum Aufnehmen des überschüssigen Klebstoffs aufweist.

8. Elektronische Steuereinheit (1) nach Anspruch 5, 6 oder 7, wobei das Druckelement (8) bei der ersten Basis (9) mindestens eine ringförmige Wölbung (13) aufweist, die zum Eingriff mit dem Sitz (12) dimensioniert ist.

9. Elektronische Steuereinheit (1) nach einem der Ansprüche 1 bis 8, wobei das Druckelement (8) durch Silikon gebildet ist.

10. Elektronische Steuereinheit (1) nach Anspruch 9, wobei das Silikon eine Härte aufweist, die 80 ± 5 ShoreA beträgt.

11. Elektronische Steuereinheit (1) nach einem der Ansprüche 1 bis 10, wobei das Druckelement (8) eine Gesamthöhe von 27 mm aufweist und eine Kegelstumpfform hat, die aufweist eine größere erste Basis (9), die an dem Deckel (7) anliegt und einen Durchmesser von 10 mm aufweist, und eine kleinere zweite Basis (10), die an der Leiterplatte (2) anliegt und einen Durchmesser von 7 mm hat.

12. Elektronische Steuereinheit (1) nach einem der Ansprüche 1 bis 11, wobei das Druckelement (8) zwischen dem Deckel (7) und der Leiterplatte (2) mit einem theoretischen Eingriff von 1 mm bis 1,5 mm zusammengedrückt ist.

13. Elektronische Steuereinheit (1) nach Anspruch 12, wobei das Druckelement (8) zwischen dem Deckel (7) und der Leiterplatte (2) mit einem theoretischen Eingriff zusammengedrückt ist, der gleich 1,2 mm ist.

14. Elektronische Steuereinheit (1) nach einem der Ansprüche 1 bis 13, wobei die Basis (6) des Gehäuses (5) eine Gegenfläche (15) aufweist, die sich bei dem Druckelement (8) befindet und eine Anlagefläche für die Leiterplatte (2) bildet, um als mechanisches Gegenstück für das Druckelement (8) zu wirken.

15. Elektronische Steuereinheit (1) nach einem der Ansprüche 1 bis 14, wobei die Leiterplatte (2) frei von elektrischen/elektronischen Komponenten (3) und Schweißstellen in dem Anlagebereich des Druckelements (8) ist.

## Revendications

1. Unité de contrôle électronique (1), comprenant :
une carte de circuits imprimés (2) qui supporte un circuit électrique, une pluralité de composants électriques/électroniques (3) reliés électriquement au circuit électrique, et au moins un connecteur (4) relié électriquement au circuit électrique;
un boîtier (5) qui reçoit la carte de circuits imprimés (2) et comprend une base (6) qui supporte , en partie inférieure, la carte de circuits imprimés (2), et un couvercle (7) qui, en partie supérieure, ferme la base (6); et
au moins un élément presseur (8) qui est constitué d'un matériau élastiquement déformable, est disposé en position centrale et est comprimé entre le couvercle (7) et la carte de circuits imprimés (2) pour appuyer avec interférence contre la carte de circuits imprimés. (2);
l'unité de contrôle électronique (1) est **caractérisée en ce qu'**une seconde base (10) de l'élément presseur (8) reposant sur la carte de circuits imprimés (2) présente un trou borgne central (11).

2. Unité de contrôle électronique (1) selon la revendication 1, dans laquelle l'élément presseur (8) présente une forme tronconique ayant une première base (9) plus large reposant sur le couvercle (7) et une seconde base plus petite (10) reposant sur la carte de circuits imprimés (2).

3. Unité de contrôle électronique (1) selon la revendication 1 ou 2, dans laquelle une seconde base (10) de l'élément presseur (8) reposant sur la carte de circuits imprimés (2) est arrondie..

4. Unité de contrôle électronique (1) selon l'une des revendications 1 à 3, dans laquelle une première base (9) de l'élément presseur (8) reposant sur le couvercle (7) est fixée au couvercle (7) par collage.

5. Unité de contrôle électronique (1) selon l'une des revendications 1 à 4, dans laquelle le couvercle (7) comprend un logement (12) qui reçoit une première base (9) de l'élément presseur (8) reposant sur le couvercle (7).

6. Unité de contrôle électronique (1) selon la revendication 5, dans laquelle la première base (9) de l'élément presseur (8) est fixée au couvercle (7) par collage.

7. Unité de contrôle électronique (1) selon la revendication 6, dans laquelle, au niveau de la première base (9), l'élément presseur (8) présente au moins un canal latéral axial (14) pour éliminer l'excès de colle.

8. Unité de contrôle électronique (1) selon la revendication 5, 6 ou 7, dans laquelle, au niveau de la première base (9), l'élément presseur (8) présente au moins un renflement annulaire (13) dimensionné par interférence à l'intérieur du logement (12).

9. Unité de contrôle électronique (1) selon l'une des revendications 1 à 8, dans laquelle l'élément presseur est formé de silicone.

10. Unité de contrôle électronique (1) selon la revendication 9, dans laquelle la silicone a une dureté égale à 80 ± 5 shoreA.

11. Unité de contrôle électronique (1) selon l'une des revendications 1 à 10, dans laquelle l'élément presseur (8) a une hauteur totale de 27 mm et présente une forme tronconique ayant une première base (9) plus large reposant sur le couvercle (7) d'un diamètre de 10 mm et une seconde base (10) plus petite reposant sur la carte de circuits imprimés (2) d'un diamètre de 7 mm.

12. Unité de contrôle électronique (1) selon l'une des revendications 1 à 11, dans laquelle l'élément presseur (8) est comprimé entre le couvercle (7) et la carte de circuit imprimé (2) avec une interférence théorique de 1 mm à 1,5 mm.

13. Unité de contrôle électronique (1) selon la revendication 12, dans laquelle l'élément presseur (8) est comprimé entre le couvercle (7) et la carte de circuits imprimés (2) avec une interférence théorique égale à 1,2 mm.

14. Unité de contrôle électronique (1) selon l'une des revendications 1 à 13, dans laquelle la base (6) du boîtier (5) présente un plan d'opposition (15) qui est disposé au niveau de l'élément presseur (8) et constitue une surface d'appui pour la carte de circuits imprimés (2) de façon à agir en tant qu'opposition mécanique à l'élément presseur (8).

15. Unité de contrôle électronique (1) selon l'une des revendications 1 à 14, dans laquelle la carte de circuits imprimés (2) est exempte de composants électriques/électroniques et de soudures dans la zone où repose l'élément presseur (8).
